# EUROPEAN PATENT APPLICATION

(11) **EP 3 579 285 A1**
(43) Date of publication of application: **11.12.2019**
(21) Application number: 18290065.4
(22) Date of filing: 08.06.2018
(51) Int. Cl.: H01L 31/0224, H01L 31/18, H01L 31/0216

(54) **METHOD TO OBTAIN A PHOTOVOLTAIC DEVICE**

(71) Applicant: Total SA, 92400 Courbevoie (FR)
(72) Inventor: POULAIN, Gilles, 1060 Saint-Gilles (BE); HARDER, Nils-Peter, 75014 Paris (FR)
(74) Representative: Croonenbroek, Thomas Jakob

(57) **Abstract**

The invention concerns a method for manufacturing a photovoltaic device (15) having metallic front contacts (17), comprising the steps:
• providing a mono- or multicrystalline silicon substrate (1) comprising a predetermined quantity of a dopant and having a front surface (3) and a back surface (5), said dopant comprising either a p-type dopant or a n-type dopant,
• forming an oxide layer on the front surface (3) of the substrate (1),
• depositing at least one dopant containing layer of silicon based material (9, 11) comprising at least a layer of amorphous silicon (9) on the oxide layer on the front surface (3),
• annealing the dopant containing layer of silicon based material (9, 11),
• local heat curing of the dopant containing layer of silicon based material (9, 11) using laser radiation along a contact pattern, to form metallic contacts (17) along said contact pattern.

## Description

### FIELD OF INVENTION

The invention relates to a method for manufacturing a photovoltaic device, in particular for manufacturing a front contact photovoltaic device.

### BACKGROUND AND PRIOR ART

Photovoltaic devices with front contacts are well known in the art. For example US20050189015, US20110139230, US6091021 disclose silicon wafer based photovoltaic devices including a front contact or front electrodes. By convention, a front side or surface of a photovoltaic device is the side through which the sunlight penetrates for generation of an electrical current by the photovoltaic effect at the p-n / n-p junction of the photovoltaic device. The backside or back-surface of the photovoltaic device is the side opposite to the front side.

Typically, the front electrical contacts are made of metal, deposited on one or more passivation layers at the front surface of the photovoltaic device.

Application techniques of front electrical contacts may include in particular printing and firing through of contacts by depositing a pattern using serigraphy or ink-jet printing with inks containing a solution of metallic particles, which is then heat-cured. A firing step then makes the electrical contacts penetrate through the passivation layer or layers.

The firing through of the electrical contacts requires heating of the cell, at temperatures generally over 800°C - 900°C to cause penetration of the electrical contacts to form a contact with the underlying semiconductor wafer material.

However, the heat treatment stimulates the penetration of metallic atoms into the silicon substrate. In case of shallow emitters with low doping concentration, the penetration by the metal causes notably increased recombination and therefore loss of efficiency of the photovoltaic device.

To counterbalance the recombination due to the penetration of metallic atoms, local n- or p-doping in higher concentrations around the contact areas can be generated.

The article "Laser-assisted Selective Emitters and the Role of Laser Doping" by F. Colville (Photovoltaics International PVI5-01_3 - 2010) discloses to use heating on, for example, screen printed phosphorous doped paste, to make so-called buried contacts using laser ablation to create trenches in which the contacts are buried, diffusion masking and single-step laser doping.

Colville discloses the use of a dopant containing layer, as an "extra 'film' or layer". Colville also discloses the use of laser to simultaneously perform front surface scribing of a dopant containing silicon nitride SiNₓ film to perform localized high doping. The presence of a significant nitrogen concentration in the film that serves as dopant source causes migration of part of said nitrogen atoms in the substrate, which makes this technique for generating increased doping difficult.

In most cases, the dopants come from a temporarily applied, functional doping layer, which must be etched away before applying additional passivation and/or antireflective coatings.

However, the additional steps to generate the local doping, using for example liquid deposition and thermal migration or ion implantation, cause increased production costs.

Thus, it will be appreciated that there exists a need in the art for an improved method for manufacturing efficient electrical front contacts for a photovoltaic device with a simple production process sequence.

### SUMMARY OF THE INVENTION

In order to overcome the aforementioned drawbacks, the invention has for object a method for manufacturing a photovoltaic device having metallic front contacts, comprising the steps:
- providing a mono- or multicrystalline silicon substrate comprising a predetermined quantity of a dopant and having a front surface and a back surface, said dopant comprising either a p-type dopant or a n-type dopant,
- forming an oxide layer on the front surface of the substrate,
- depositing at least one dopant containing layer of silicon based material comprising at least a layer of amorphous silicon on the oxide layer on the front surface,
- annealing the dopant containing layer of silicon based material,
- local heat curing of the dopant containing layer of silicon based material using laser radiation along a contact pattern, to form metallic contacts along said contact pattern.

The process combines in a single step the steps of annealing the layer of amorphous silicon into polycrystalline silicon and the step of doping of the front surface.

Also, the step of local heat curing using laser radiation allows to combine the step of opening of the passivation layer or firing thtough of metallic contacts and the step of local doping in another single step. In addition, no etching of a residual dopant containing additional layer is required.

The process according to the invention may further have one or more of the following characteristics, taken separately or in combination.

The dopant containing layer of silicon based material comprises a dopant containing amorphous silicon layer, deposited over the whole front surface of the silicon substrate.

The step of depositing at least one dopant containing layer of silicon based material comprising at least a layer of amorphous silicon on the front surface, comprises the steps of:
- depositing a layer of undoped or dopant containing layer of amorphous silicon,
- depositing a layer of phospho- or borosilicate glass on the front surface after depositing the layer of amorphous silicon,
- annealing the layer of amorphous silicon and the layer of phospho- or borosilicate glass.

The amorphous silicon layer has a thickness comprised between 5 and 30nm, in particular between 7 and 15nm.

The phospho- or borosilicate glass contains respectively phosphorus or boron atoms as dopant, with a concentration comprised between 5.10¹⁸ and 2.10²⁰cm⁻³.

The local heat curing of the dopant containing layer of silicon based material using laser radiation along a contact pattern comprises a step of laser ablation of the silicon based based material.

The local heat curing of the dopant containing layer of silicon based material using laser radiation along a contact pattern comprises a step of firing through of a metallic and glass or silicon particle containing paste along the contact pattern to create the metallic contacts.

The metallic and glass or silicon particle containing paste is applied on the contact pattern using jet printing.

At least one additional layer of antireflective coating is applied on the dopant containing layer of silicon based material.

The materials for the at least one antireflective coating may in particular be selected from the following list: silicon nitride SiNₓ, silicon carbide SiC, aluminium nitride AIN, aluminium oxide AlOx, titanium oxide TiOx.

The additional antireflective coating is applied before the step of local heat curing the dopant containing layer of silicon based material using laser radiation along the contact pattern to form the metallic contacts.

### BRIEF DESCRIPTION OF THE DRAWINGS

Other characteristics and benefits of the invention will appear in the following description based on the enclosed figures among which:
- figure 1 is a linear flow chart of the main steps of a first embodiment of the method according to the invention,
- figures 2 to 11 illustrate the main steps of the method in figure 1,
- figures 9 to 11 illustrate a second embodiment of the method,
- figures 12 and 13 illustrate a third embodiment of the method,
- figures 14 to 17 illustrate a possible back-surface treatment for the photovoltaic device.

### DETAILED DESCRIPTION

The embodiments described hereafter are given in an illustrating example and are not limited to them. The description refers to particular embodiments, but further embodiments can be obtained by combining or slightly altering features for example of two different embodiments. Said other embodiments are also within the scope of the invention. On all figures, the same reference applies to a single element or equivalent elements.

Furthermore, as the invention relates in particular to the front side of the photovoltaic device, the description hereafter focuses on the steps relating to front side. An example of steps for realisation of the backside of the photovoltaic device is given in an illustrative fashion.

The starting point of the process 100 is a semiconductor substrate 1, in particular a doped silicon wafer. The semiconductor substrate 1 may in particular be a monocrystalline or a multicrystalline silicon wafer.

The silicon substrate 1 comprises a predetermined quantity of a dopant which is either a p-type dopant (like boron for example) or an n-type dopant (like phosphorus for example). The provided silicon substrate 1 has also undergone a saw damage removal process like wet chemical etching before application of the next processing steps.

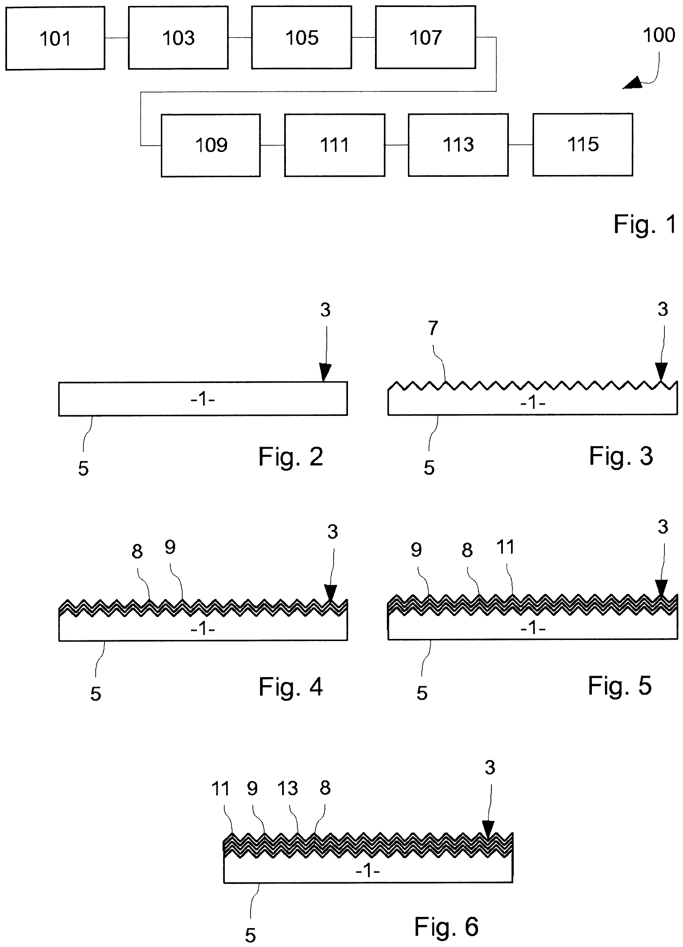

In a first step 101, a silicon substrate 1 is provided (see figure 2) having a front surface 3 and a back surface 5. The silicon substrate 1 is preferentially made of mono-crystalline silicon, but may also be made of multicrystalline silicon.

As already stated, the front surface 3 is the face that is impacted first by the sunlight rays.

In a second step 103, the front surface 3 of silicon substrate 1 is textured (see figure 3) for example with randomly distributed upright pyramids 7. The pyramids consists for example of four planes and four edges with an angle between the planes and the base of about 54,75°. Random texturing may be formed by submitting {100} silicon wafers to a lowly concentrated alkaline solution buffered with isopropyl alcohol (IPA) and containing dissolved silicon at elevated temperature. The conditions are controlled in a way to ensure that the pyramids have for example a height between 1 - 10µm.

Texturing is illustrated on figure 3 by a saw-tooth profile of the front surface 3 for improved light trapping. However, other texturing methods may be used like for example in WO2011/023894 in the name of the applicant and enclosed by reference. Although generally realized on wafers to trap sunlight more efficiently, the texturing step is highly recommended with respect to the present invention but not necessary for its functioning.

Texturing the back surface 5 can be realized in order to improve light trapping.

Texturing the back surface 5 may be done using alkaline etching of random pyramids as with the front surface 3.

The third step 105, illustrated in figure 4, is the deposition of a silicon oxide layer 8 followed by the deposition of an amorphous silicon layer 9 on top of the oxide layer 8, here in particular with dopant atoms (n- or p-dopant) on the front surface 3.

Silicone oxide is either added, for example by sputtering or chemical vapor deposition, or grown by oxidation of a topmost layer of the silicon substrate 1. The silicone oxide layer 8 has a thickness comprised between 1 and 10nm, generally 1 to 2.5nm, through which light can penetrate and charge carriers can tunnel.

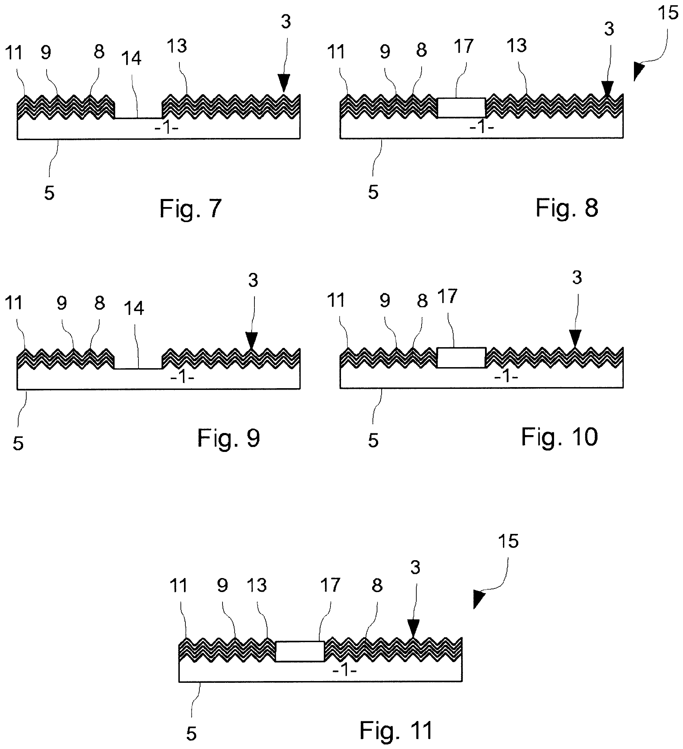

The amorphous silicon layer 9 is deposited on top of the oxide layer 8, in the present embodiment with a thickness comprised between 5 and 30nm, preferably 15 to 25nm and even more prefered 5 to 15nm. This thickness is sufficient to slow down surface recombinaion, while the obtained passivation layer 9 remains sufficiently transparent for the obtained photovoltaic cell 15 (see figure 8) to have a good efficiency.

The amorphous silicon layer 9 may in particular be deposited by low pressure chemical vapor deposition (LPCVD) of amorphous silicon and dopant (boron or phosphorus).

A fourth step 107 (not represented in the figures), is a step of annealing of the amorphous polysilicon layer 9 to transform it into a polycrystalline silicon layer 9, thus forming a passivation layer comprising the oxide layer 8 and the obtained polycrystalline silicon layer 9. This is achieved in a furnace, with temperatures between 800°C and 1100°C. The high temperatures of this annealing step 107 can also cause part of the dopant contained initially in the amorphous silicon layer 9 to migrate in the underlying substrate 1.

The dopant in the polysilicon is preferably of the same n- or p-type as the dopant in the bulk of the silicon substrate 1. In that case, the p-n junction is then created at the rear side.

In covering the whole front surface 3 with the silicon oxide layer 8 and a polycrystalline silicon layer 9, a passivation effect is obtained.

The excess of dopant around the front surface will help slow down the recombination through opposite type dopant diffusion and surface recombination.

Alternatively to incorporating dopant directly in the amorphous silicon layer 9, it is possible to provide dopants for said amorphous silicon layer 9 for example by providing an additional layer of boro- or phosphosilicate glass 11 (BSG/PSG) which may be applied on said layer 9. The boro- or phosphosilicate glass 11 is also a dopant containing, silicon based material, since it contains a fraction generally higher than 70% of silicon oxide SiO₂ (silica).

When a boro- or phosphosilicate glass layer 11 is present, the underlying amorphous or polysilicon layer 9 can be selected as dopant-free, the phospho- or borosilicate glass being the source of the additional dopant atoms (boron or phosphorus).

The phospho- or borosilicate glass layer 11 acts as an additional or replacement source for dopant atoms during a subsequent annealing step. To provide sufficient dopant atoms, the phospho- or borosilicate glass contains respectively phosphorus or boron atoms as dopant, with a concentration comprised between 5.10¹⁸ and 2.10²⁰cm⁻³.

Borosilicate glass is in particular indicated if the dopant in the amorphous silicon layer 9 and/or substrate 1 is boron, and phosphosilicate glass is in particular indicated if the dopant in the amorphous silicon layer 9 and/or substrate 1 is phosphorus. The additional boro- or phosphosilicate glass is applied with a thickness comprised between 5 and 25nm, preferably around 10 to 15nm.

Borosilicate and phosphosilicate glass can contain higher concentrations of boron or respectively phosphorus than the amorphous silicon.

When a boro- or phosphosilicate glass layer 11 is present, the underlying amorphous or polysilicon layer 9 can be dopant-free, the phospho- or borosilicate glass being the source of the additional dopant atoms.

This fifth step 109 is illustrated in figure 5.

For depositing the phospho- or borosilicate glass layer 11, chemical vapor deposition, in particular plasma enhanced chemical vapor deposition (PECVD) may be used.

In a sixth step 111 shown in figure 6, an antireflective coating 13 (ARC) for example of silicon nitride SiNx or silicon carbide SiC is deposited on top of the polycrystalline layer 9 at least on the portions not to be covered by metallic contacts 17 (active surface). In the depicted example, the antireflective coating 13 covers the whole front surface 3.

In particular, at least one additional layer of antireflective coating 13 is applied on the dopant containing layer of silicon based material, either the amorphous silicon layer 9, or the phospho or borosilicate glass 11. Materials for said antireflective coating or coatings 13 may in particular be selected from the following list: silicon nitride SiNₓ, silicon carbide SiC, aluminium nitride AIN, aluminium oxide AlOx, titanium oxide TiOx.

In a seventh step 113 shown in figure 7, openings or trenches 14 are formed in the antireflective coating 13 and the underlying polycrystalline silicon and boro- or phosphosilicate layers 9, 11. Said openings are dug using local heat curing through laser radiation, here in the form of laser ablation, on the areas which shall present the metallic contacts (e.g. interdigited line pattern).

The laser ablation is performed using for example pulsed high energy green (532nm Nd:YVO₄ laser) or ultraviolet (335nm Nd:YAG laser) laser light pulses, with careful calibration of radiated power, pulse length and frequency to avoid excessive damage to the underlying bulk silicon in the substrate 1. The polycrystalline silicon and boro- or phosphosilicate layers 9, 11 and the substrate 1 underneath are in particular melted on a depth of 500nm to 3µm.

The temperatures reached during the ablation drive atoms from the ablated layers deeper in the bulk of the silicon wafer 1 by partial refusion of both the ablated layers 9, 11, 13 and a portion of the underlying substrate silicon. Since the ablated layers 9, 11, 13 comprise essentially silicon and dopant atoms, the ablation results in locally higher dopant concentration under the openings or trenches 14 with a minimal amount of undesired atoms other than silicon.

The additional laser ablation step 113 ensures a locally higher dopant concentration during the opening of the contact pattern.

In an eighth step 115, metallic contacts 17 are deposited in the ablated trenches or openings 14, which form a contact pattern, in particular an interdigited or an elongated parallel (so called "fingers") contact pattern.

The metal used for the metallic contacts 17 may be aluminum and/or silver, and in particular a eutectic mixture of two or more metals to cause melting of the metal of the contacts 17 without melting the silicon substrate 1.

The metallic contacts 17 may as an alternative be plated specifically on the ablated pattern.

The metallic contacts 17 are deposited specifically in the laser-ablated trenches or openings 14, where the dopant concentration in the doped silicon substrate 1 is higher. Therefore, even if some metallic atoms from the metallic contacts 17 migrate in the underlying substrate 1, the increased dopant content cancels the potential loss due to recombination during annealing or heat curing steps of the metallic contacts 17.

Figures 9 to 11 illustrate a different embodiment of the method, indicated in the case of donor type doping (n-type), where the ablation of a silicon nitride SiNₓ antireflective coating may drive nitrogen (acceptor) atoms in the silicon substrate 1 underneath the ablated contact pattern.

The steps 101 to 109 are identically used in this embodiment.

In this particular embodiment, the ablation step is carried out before the deposition of the SiNₓ antireflection coating 13.

In figure 9, the ablation of a contact pattern is here carried out on a substrate featuring the oxide layer 8, the polycrystalline silicon layer 9 and the phospho- or borosilicate glass layer 11 (as in figure 5), while the antireflective coating 13 has not yet been implemented.

In figure 10, metallic contacts 17 are deposited on the ablated contact pattern, in similar fashion as previously descibed.

In figure 11, the substrate 1 carrying the oxide layer 8, the polycrystalline silicon layer 9, the phospho- or borosilicate glass layer 11 and the metallic contacts 17 is covered with an antireflection coating 13, in particular silicon nitride SiNx. The antireflection coating 13 is deposited using a mask that covers the metallic contacts 17, so that said contacts 17 are not covered by the antireflection coating 13.

In this embodiment, the laser ablation is performed on the polycrystalline silicon layer 9 and the phospho- or borosilicate layer 11, while the nitrogen containing antireflection coating 13 is not yet applied. Therefore, less acceptor type nitrogen atoms are driven in the silicon of the substrate 1.

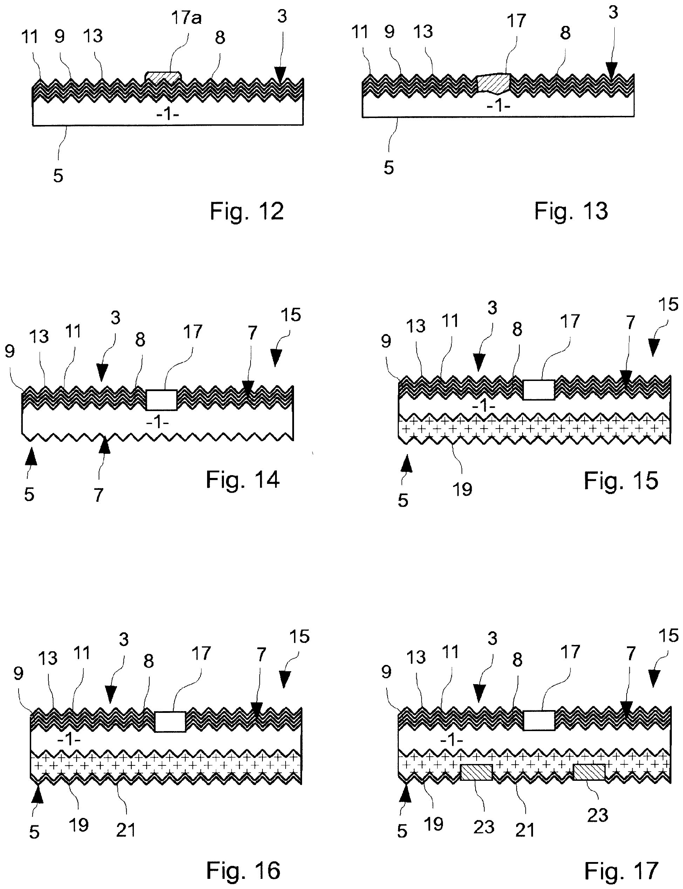

Another embodiment of the method is illustrated in figures 12 and 13.

The method remains unchanged until the step 113 of laser ablation of the annealed amorphous silicon layer 9. Instead, a paste 17a containing metallic particles and glass or silicon frit particles is added specifically along the contact pattern, as represented in figure 12, on the unopened silicon based layers 9, 11, and possibly the antireflection coating 13.

The paste 17a is for example applied using jet printing.

A laser heat curing step is then locally applied on the paste 17a along the contact pattern, which causes partial melting of the glass or silicon particles, and thus a penetration of the metal contained in the paste through the antireflection coating 13 (if present), the phospho- or borosilicate glass 11, and through the silicon oxide and amorphous silicon layer 9, by partial refusion of said layers along the contact pattern.

The laser apparatus used to fire through the glass frit and metal particle containing paste 17a may in particular be of the same type as already mentioned for ablation, but with more diffuse or less powerful radiation, and longer pulse durations to allow deeper layers to melt while preventing sublimation.

The method 100 according to the invention uses the amorphous silicon layer 9 and/or the phospho- or borosilicate glass layer 11 both as a dopant source during the local heat curing used during the steps of generating the metallic contacts 17 and as a passivating layer.

The local heat curing performed with laser radiation is either an ablation of passivation and/or antireflection coating layers 9, 11, 13, or the partial melting and firing through of a metal and glass frit particle containing paste 17a,

The step of annealing the amorphous silicon layer 9 combines the actual annealing with a dopant diffusion at the front surface 3 which creates a light dopant gradient orthogonal to said front surface 3. This light dopant gradient counterbalances recombination of charge carriers as the front surface if the same dopant type is used in the amorphous silicon layer 9 and in the substrate 1.

The step of ablating the amorphous silicon layer 9 combines the creation of the openings 14 for the metallic contacts 17 and the injection of additional dopant atoms in the bulk silicon under said metallic contacts 17.

The figures 14 to 17 illustrate a possible treatment for the rear surface of the photovoltaic device 15.

The rear surface 5 is at first also textured, for example using the random pyramid method as illustrated in figure 3 in the case of the front surface 3 (figure 14). The random texturing may be performed as indicated in the case of the front surface (low concentration alcaline solution), in particular with similar temperature, concentration and timing parameters.

A thick layer of doped polycrystalline silicon 19 is then applied to the textured rear surface 5, as depicted in figure 15. The dopant contained in the thick polycrystalline silicon layer 19 is p-type in case of a n-type doped substrate 1, and n-type in case of a p-type doped substrate 1. The doped thick polycrystalline silicon layer 19 creates the junction at the back, where considerations about transparency are less important.

The thick polycrystalline silicon layer 19 is then covered in a back surface antireflection coating 21 ("BARC" see figure 16). The back surface anti reflection coating 21 is for example silicon nitride SiN, silicon carbide SiC or silicate glass. The back surface antireflection coating 21 may also serve as passivation layer, or an additional, dedicated passivation layer may be implemented. The back surface antireflection coating 21 may in particular be a stack of several layers.

In a case where additional back-contacts are required, the back surface anti reflection coating 21 is then opened and the metallic back contacts 23 are deposited in the openings, as depicted in figure 17. The back contacts 23 are possibly deposited using the same methods as described for the front contacts 17.

Other embodiments can be obtained wherein the back surface 5 is not textured. In such processes, the back surface antireflection coating 21 is even more indicated.

The steps to form the junction and back surface 5 treatment are here presented as performed sequentially after the steps of the method 100 to obtain the front surface 3. However, steps performed on the front surface 3 and steps performed on the back surface 5 can be done in an alternating or simultaneous fashion, in particular when similar atmosphere, vacuum, temperature and/or alignment conditions are used.

For example, the step 101 of random texuring of the front surface 3 may be performed at the same time and in the same bath as the step of texturing the back surface 5.

The invention allows the combination of different operations in a reduced number of steps, and no etching away of a dedicated dopant carrying layer or addition of a dedicated passivation layer is required.

## Claims

1. Method for manufacturing a photovoltaic device (15) having metallic front contacts (17), comprising the steps:
• providing a mono- or multicrystalline silicon substrate (1) comprising a predetermined quantity of a dopant and having a front surface (3) and a back surface (5), said dopant comprising either a p-type dopant or a n-type dopant,
• forming an oxide layer on the front surface (3) of the substrate (1),
• depositing at least one dopant containing layer of silicon based material (9, 11) comprising at least a layer of amorphous silicon (9) on the oxide layer on the front surface (3),
• annealing the dopant containing layer of silicon based material (9, 11),
• local heat curing of the dopant containing layer of silicon based material (9, 11) using laser radiation along a contact pattern, to form metallic contacts (17) along said contact pattern.

2. Method according to claim 1, wherein the dopant containing layer of silicon based material (9, 11) comprises a dopant containing amorphous silicon layer (9), deposited over the whole front surface (3) of the silicon substrate (1).

3. Method according to claim 1, wherein the step of depositing at least one dopant containing layer of silicon based material (9, 11) comprising at least a layer of amorphous silicon (9) on the front surface (3), comprises the steps of:
• depositing a layer of undoped or dopant containing layer of amorphous silicon (9),
• depositing a layer of phospho- or borosilicate glass (11) on the front surface (3) after depositing the layer of amorphous silicon (9),
• annealing the layer of amorphous silicon (9) and the layer of phospho- or borosilicate glass (11).

4. Method according to claim 2 or 3, wherein the amorphous silicon layer (9) has a thickness comprised between 5 and 30nm, in particular between 7 and 15nm.

5. Method according to claim 4, wherein the phospho- or borosilicate glass contains respectively phosphorus or boron atoms as dopant, with a concentration comprised between 5.10¹⁸ and 2.10²⁰cm⁻³.

6. Method according to any of the preceding claims, wherein the local heat curing of the dopant containing layer of silicon based material (9, 11) using laser radiation along a contact pattern comprises a step of laser ablation of the silicon based based material (9, 11).

7. Method according to any of claims 1 to 5, wherein the local heat curing of the dopant containing layer of silicon based material (9, 11) using laser radiation along a contact pattern comprises a step of firing through of a metallic and glass or silicon frit particle containing paste (17a) along the contact pattern to create the metallic contacts (17).

8. Method according to claim 7, wherein the metallic and glass or silicon particle containing paste (17a) is applied on the contact pattern using jet printing.

9. Method according to any of the preceding claims, wherein at least one additional layer of antireflective coating (13) is applied on the dopant containing layer of silicon based material (9, 11).

10. Method according to claim 9, wherein the materials for the at least one antireflective coating is selected from the following list: silicon nitride SiNₓ, silicon carbide SiC, aluminium nitride AIN, aluminium oxide AlOx, titanium oxide TiOx.

11. Method according to claim 9 or 10, wherein the additional antireflective coating (13) is applied before the step of local heat curing along the contact pattern of the dopant containing layer of silicon based material (9, 11) using laser radiation to form the metallic contacts (17).
